Europäisches Patentamt

European Patent Office

Office européen des brevets

(19)

(11) Veröffentlichungsnummer: **0 240 776**
**A1**

(12) **EUROPÄISCHE PATENTANMELDUNG**

(21) Anmeldenummer: 87103785.9

(22) Anmeldetag: 16.03.87

(51) Int. Cl.³: **G 02 B 5/18**
**H 01 L 21/308, H 01 S 3/06**

(30) Priorität: 26.03.86 DE 3610333

(43) Veröffentlichungstag der Anmeldung:
14.10.87 Patentblatt 87/42

(84) Benannte Vertragsstaaten:
DE FR GB

(71) Anmelder: Siemens Aktiengesellschaft Berlin und
München
Wittelsbacherplatz 2
D-8000 München 2(DE)

(72) Erfinder: März, Reinhard, Dr.
Comeniusstrasse 4,
D-8000 München 80(DE)

(72) Erfinder: Heise, Gerhard, Dipl.-Phys.
Bert-Brecht-Allee 10
D-8000 München 83(DE)

(54) Verfahren zur Herstellung eines Oberflächengitters mit einer bestimmten Gitterkonstanten auf einem tieferliegenden Oberflächenbereich einer Mesastruktur.

(57) Verfahren zur Herstellung eines Oberflächengitters (1) mit einer bestimmten Gitterkonstanten (a) auf einem tieferliegenden Oberflächenbereich (10) einer auf der Oberfläche eines Substrats (3) aus einem Halbeitermaterial durch naßchemisches Ätzen mittels Maske erzeugten Mesastruktur (2). Es wird ein besonders einfaches und sehr billiges Verfahren dieser Art angegeben. Dazu wird die Mesastruktur (2) in eine feinstrukturierte, ein Oberflächengitter (4) mit der bestimmten Gitterkonstanten (a) aufweisende Oberfläche des Substrats (3) mittels eines anisotropen Ätzmittels geätzt, das bereits zur Herstellung des Oberflächengitters (4) verwendet wurde. Dabei wird dieses Oberflächengitter (4) in einem maskenfreien Bereich (20), der den tieferliegenden Oberflächenbereich (10) der Mesastruktur (2) definiert, unverändert in die Tiefe übertragen.

**FIG 2**

EP 0 240 776 A1

Siemens Aktiengesellschaft          Unser Zeichen
Berlin und München                  VPA 85 P 1257 E 01

Verfahren zur Herstellung eines Oberflächengitters mit
einer bestimmten Gitterkonstanten auf einem tieferliegenden Oberflächenbereich einer Mesastruktur

Die vorliegende Erfindung betrifft ein Verfahren zur
Herstellung eines Oberflächengitters mit einer bestimmten Gitterkonstanten auf einem tieferliegenden Oberflächenbereich einer stufigen Struktur nach dem Oberbegriff des Patentanspruchs 1.

Für die Realisierung eines DFB-MCRW-Lasers in Einschrittepitaxie ist es notwendig, Gitter in einem
tieferliegenden Bereich unmittelbar neben einem erhabenen Bereich einer Mesastruktur herzustellen. Ein DFB-
MCRW-Laser und seine Herstellung in Einschrittepitaxie
ist in der älteren Patentanmeldung P 34 37 209.1 mit dem
Titel "Verbesserung zu einem Monomoden-Diodenlaser" vorgeschlagen.

Denkbar wäre es, das Oberflächengitter auf dem
tieferliegenden Bereich durch ein Verfahren mit Mehrlagenmaskierung herzustellen. Dabei muß aber das Problem umgangen werden, daß Fotolack auf Substrate bzw.
Wafer mit Mesastrukturen nicht aufgeschleudert werden
kann.

Aufgabe der vorliegenden Erfindung ist es, ein besonders einfaches und sehr billiges Verfahren der eingangs
genannten Art anzugeben.

Diese Aufgabe wird gemäß dem kennzeichnenden Teil des
Patentanspruchs 1 dadurch gelöst, daß die stufige Struk-
Ed 1 Sti/26.03.1986

tur in eine fein strukturierte, ein Oberflächengitter mit der bestimmten Gitterkonstanten aufweisende Oberfläche des Substrats mittels eines anisotropen, in zumindest einer zur feinstrukturierten Oberfläche schrägen Richtung am langsamsten ätzenden Ätzmittels geätzt wird, wobei in einem den tieferliegenden Oberflächenbereich der stufigen Struktur definierenden maskenfreien Bereich das Relief des dem anisotropen Ätzmittel ausgesetzten Oberflächengitters der maskierten feinstrukturierten Oberfläche mehr oder weniger formgetreu aber unter Beibehaltung der bestimmten Gitterkonstanten in die Tiefe übertragen wird, wo es nach Beendigung des Ätzvorganges das gewünschte Oberflächengitter bildet.

Das erfindungsgemäße Verfahren ist selbstjustierend. Das Oberflächengitter der feinstrukturierten Oberfläche des Substrats muß nur der Bedingung genügen, daß seine Gitterkonstante mit der Gitterkonstanten des gewünschten Oberflächengitters auf dem tieferliegenden Oberflächenbereich übereinstimmt. Ansonsten kann das Profil der Rillen des Oberflächengitters der feinstrukturierten Oberfläche des Substrats weitgehend eine beliebige Form aufweisen. Dieses Gitter kann beispielsweise schwach wellig ausgebildet sein oder aber auch ein rechteckförmiges Rillenprofil aufweisen.

Vorteilhaft ist es aber, wenn gemäß dem Patentanspruch 2 das Oberflächengitter der feinstrukturierten Oberfläche des Substrats durch naßchemisches Ätzen mit zumindest im wesentlichen dem gleichen anisotropen Ätzmittel hergestellt wird, wie es beim Ätzen der stufigen Struktur verwendet wird. In diesem Fall hat das Oberflächengitter der feinstrukturierten Oberfläche des Substrats bereits von vorneherein das gleiche Rillenprofil, wie das gewünschte Oberflächengitter. Das Oberflächengitter der feinstrukturierten Oberfläche des Substrats wird in diesem Fall im wesentlichen unverändert in die Tiefe übertragen, wodurch eine sehr gute Reproduzierbarkeit des Gitters auf dem tieferliegenden Oberflächenbereich erhalten werden kann.

Bei dem erfindungsgemäßen Verfahren bleiben die von der Maske abgedeckten Bereiche der strukturierten Oberfläche als erhabene Bereiche stehen, die durch einen Stufen-übergang von den tieferliegenden Bereichen getrennt sind. Der Begriff "stufige Struktur" ist allgemein so aufzufassen, daß die Struktur Stufen aufweist. Unter der Maske, die auf dem Relief der feinstrukturierten Oberfläche dicht aufliegt, so daß in die von ihr abgedeckten feinstrukturierten Oberflächenbereiche von der Seite her kein Ätzmittel eindringen kann, bleibt das Oberflächengitter der feinstrukturierten Oberfläche stehen, mit der das in die Tiefe abgesenkte Oberflächengitter die gleiche Phasenlage aufweist. Dieses stehengebliebene Oberflächengitter auf den erhabenen Bereichen der gestuften Struktur kann im Fall des MCRW-Lasers, wo dieser erhabene Bereich streifenförmig ausgebildet ist, zur Gainkopplung verwendet werden, da über den sich räumlich ändernden Übergangswiderstand eine Modulation des Injektionsstromes stattfindet.

Die Erfindung wird beispielhaft anhand der Figuren in der folgenden Beschreibung näher erläutert. Von den Figuren zeigen:

Figur 1 in perspektivischer Darstellung ein Substrat mit einer feinstrukturierten Oberfläche in Form eines Oberflächengitters mit im Profil dreieckförmigen Rillen, das zur Herstellung einer Mesastruktur mit einer streifenförmigen Ätzmaske abgedeckt ist, und

Figur 2 das Gebilde nach Figur 1 in der gleichen Darstellung nach dem Ätzen der stufigen Struktur.

Die durch die Figuren angedeutete relativ einfache stufige Struktur bezieht sich auf die Herstellung eines
MCRW-Lasers, der im wesentlichen nur einen streifenförmigen erhabenen Bereich benötigt. Selbstverständlich
kann das Verfahren auch für kompliziertere stufige
Strukturen verwendet werden.

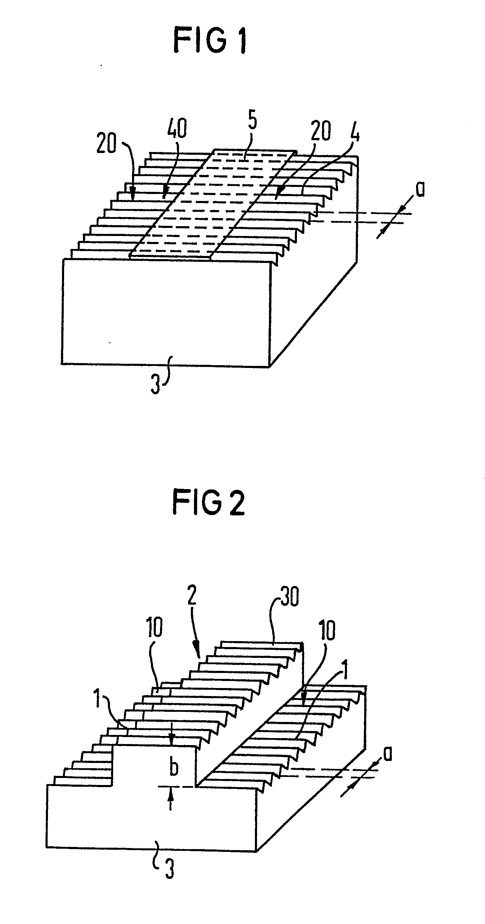

Zur Herstellung der feinstrukturierten Oberfläche 40
nach Figur 1 wird beispielsweise so vorgegangen, daß
in die Oberfläche eines Wafers 3 mit den für die spätere Verwendung erforderlichen epitaktischen Schichtsystem, die in den Figuren nicht dargestellt sind, naßchemisch mit einem anisotropen Ätzmittel ein Oberflächengitter 4 mit im Profil V-förmigen Rillen geätzt
wird, und zwar durch Freilegen der (111)-Flächen des
Kristallmaterials des Substrats unter der Oberfläche 40.
Dieses Oberflächengitter 4 erstreckt sich über die ganze
Oberfläche 40 und weist die Gitterkonstante a auf. Als
Maske wird Fotolack verwendet, der mittels eines Interferenzmusters belichtet wird.

Zur Herstellung der stufigen Struktur 2 nach Figur 2 mit
dem streifenförmigen erhabenen Bereich 30 wird auf das
Oberflächengitter 4 erneut Fotolack aufgetragen, so, daß
er auf dem Relief dieses Gitters überall dicht aufliegt.
Durch Maskenbelichtung wird ein Fotoresist-Streifen 5
erzeugt, dessen Längsrichtung quer, beispielsweise senkrecht, zu den Rillen des Oberflächengitters 4 verläuft,
und unter dem der erhabene Bereich 30 entsteht. Die
übrigen Bereiche 20 des Oberflächengitters 4, die an die
Längsseiten des Fotoresist-Streifens 5 grenzen, werden
ganz freigelegt, damit bei der Herstellung der stufigen
Struktur 2 das Ätzmittel ungehindert auf diese Bereiche

einwirken kann. Dabei wird die Oberfläche 40 mit dem darauf befindlichen Fotoresist-Streifen 5 mit dem gleichen Ätzmittel wie bei der Herstellung des Oberflächengitters 4 geätzt. Dadurch wird dieses Gitter in den Bereichen 20 seitlich neben dem Fotoresist-Streifen 5 unverändert in die Tiefe übertragen. Es entstehen die tieferliegenden Oberflächenbereiche 10 mit den gewünschten Oberflächengittern 1, die an den dazwischenliegenden streifenförmigen erhabenen Bereich 30 grenzen, auf dem der Rest des Oberflächengitters 4 nach Figur 1 stehengeblieben ist. Das stehengebliebene Gitter und die Gitter 1 auf den tieferliegenden Bereichen 10 haben die gleiche Phasenlage und die gleiche Gitterkonstante a.

Für die Realisierung einer solchen stufigen Struktur 2 kann beispielsweise ein Substrat 3 aus GaAs oder GaAlAs mit einem Ätzmittel geätzt werden, das aus einer Mischung aus Schwefelsäure, Wasserstoffperoxid und Wasser besteht. Bei einer praktischen Realisierung einer Struktur 2 wurde ein Substrat 3 aus GaAs oder aus einer GaAlAs mit einem Ätzmittel geätzt, das aus etwa 0,75 bis 3 Teilen konzentrierter Schwefelsäure, 8 Teilen 30%igem Wasserstoffperoxid und aus 35 Teilen Wasser bestand. Die Prozentangabe versteht sich als Volumenprozent.

Zur Herstellung des Oberflächengitters 4 wurde die Oberfläche des Substrats etwa 1 Minute lang mit diesem Ätzmittel geätzt, und zur Herstellung der stufigen Struktur 2 wurde etwa 1 - 5 Minuten lang geätzt, wobei die Versenktiefe b von 0,2 - 1,4 μm beträgt. Die Gitterkonstante a lag im Submikronbereich etwa bei 0,3 μm. Günstig ist es, die Ätzvorgänge bei niedrigen Temperaturen, beispielsweise bei oder in der Nähe von 0°C vorzunehmen.

- 6 -    VPA 85 P 1257  E 01

Vorzugsweise wird eine stufige Struktur 2 auf einem Substrat 3 aus InP oder aus einem quarternären Material auf
InP-Basis, beispielsweise aus InGaAsP erzeugt. Als Ätzmittel ist anstelle der obengenannten Mischung eine Ätzmischung aus 10 Teilen 48%igem HBr, einem Teil gesättigten Bromwassers und 40 Teilen Wasser geeignet, wobei
sich auch hier die Prozentangabe als Volumenprozent
versteht. Diese Mischung mit dem angegebenen oder einem
ähnlichen Mischungsverhältnis erzeugt V-förmig gefurchte
Gitter, die mit dieser Mischung wie oben angegeben in
die Tiefe übertragen werden können.


2 Patentansprüche
2 Figuren

Patentansprüche

1. Verfahren zur Herstellung eines Oberflächengitters (1) mit einer bestimmten Gitterkonstanten (a) auf einem tieferliegenden Oberflächenbereich (10) einer auf der Oberfläche eines Substrats (3) aus einem Kristallmaterial durch naßchemisches Ätzen mittels Maske erzeugten stufigen Struktur (2), insbesondere einer Mesastruktur, d a d u r c h  g e k e n n z e i c h n e t , daß die stufige Struktur (2) in eine feinstrukturierte, ein Oberflächengitter (4) mit der bestimmten Gitterkonstanten (a) aufweisende Oberfläche (40) des Substrats (3) mittels eines anisotropen, in zumindest einer zur feinstrukturierten Oberfläche (40) schrägen Richtung am langsamsten ätzenden Ätzmittels geätzt wird, wobei in einem den tieferliegenden Oberflächenbereich (10) der stufigen Struktur (2) definierenden maskenfreien Bereich (20) das Relief des dem anisotropen Ätzmittel ausgesetzten Oberflächengitters (4) der maskierten, feinstrukturierten Oberfläche (40) mehr oder weniger formgetreu aber unter Beibehaltung der bestimmten Gitterkonstanten (a) in die Tiefe übertragen wird, wo es nach Beendigung des Ätzvorganges das gewünschte Oberflächengitter (1) bildet, und wobei das Substrat aus InP oder einem quarternären Material auf InP-Basis und das anisotrope Ätzmittel aus einer Mischung aus HBr, gesättigtem Bromwasser und Wasser besteht, oder wobei das Substrat aus GaAs oder GaAlAs und das anisotrope Ätzmittel aus einer Mischung aus $H_2SO_4$, $H_2O_2$ und Wasser besteht.

2. Verfahren nach Anspruch 1 oder 2, d a d u r c h  g e k e n n z e i c h n e t , daß das Oberflächengitter (4) der feinstrukturierten Oberfläche (40) des Substrats (3) durch naßchemisches Ätzen mit zumindest im wesentlichen dem gleichen anisotropen Ätzmittel hergestellt wird, wie es beim Ätzen der stufigen Struktur (2) verwendet wird.

Ed 1 Sti/11.02.1987

FIG 1

FIG 2

0240776

Europäisches
Patentamt

**EUROPÄISCHER RECHERCHENBERICHT**

Nummer der Anmeldung

EP 87 10 3785

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | APPLIED PHYSICS LETTERS, Band 28, Nr. 1, 1. Januar 1976, Seiten 44-46, American Institute of Physics, New York, US; W.-T. TSANG et al.: "Profile and groove-depth control in GaAs diffraction gratings fabricated by preferential chemical etching in H2SO4-H2O2-H2O system" * Seite 44 * | 1 | G 02 B 5/18<br>H 01 L 21/308<br>H 01 S 3/06 |
| | --- | | |
| Y | PATENT ABSTRACTS OF JAPAN, Band 9, Nr. 201 (E-336)[1924], 17. August 1985; & JP-A-60 66 485 (TOSHIBA K.K.) 16-04-1985 * Zusammenfassung * | 1 | |
| | --- | | |
| A | PATENT ABSTRACTS OF JAPAN, Band 8, Nr. 256 (E-280)[1693], 22. November 1984; & JP-A-59 127 895 (FUJIKURA DENSEN K.K.) 23-07-1984 * Zusammenfassung * | 1 | RECHERCHIERTE SACHGEBIETE (Int. Cl.4)<br><br>H 01 S<br>H 01 L<br>G 02 B |
| | --- | | |
| A | PATENT ABSTRACTS OF JAPAN, Band 8, Nr. 250 (E-279)[1687], 16. November 1984; & JP-A-59 126 693 (FUJIKURA DENSEN K.K.) 21-07-84 * Zusammenfassung * | 1 | |
| | ---    -/- | | |

Der vorliegende Recherchenbericht wurde für alle Patentansprüche erstellt.

| Recherchenort | Abschlußdatum der Recherche | Prüfer |
|---|---|---|
| DEN HAAG | 09-07-1987 | GNUGESSER H.M. |

Europäisches
Patentamt

**EUROPÄISCHER RECHERCHENBERICHT**

Nummer der Anmeldung

EP 87 10 3785

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 9, Nr. 266 (E-352)[1989], 23. Oktober 1985; & JP-A-60 111 488 (KOGYO GIJUTSUIN JAPAN) 17-06-1985 * Zusammenfassung * ----- | 1 | |

RECHERCHIERTE
SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| DEN HAAG | 09-07-1987 | GNUGESSER H.M. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82